# FASCICULE DE BREVET EUROPEEN

(11) **EP 4 211 431 B1**
(45) Date de publication et mention de la délivrance du brevet: **08.01.2025**
(21) Numéro de dépôt: 21785938.8
(22) Date de dépôt: 13.09.2021
(51) Int. Cl.: G01H 1/00, G01H 11/08, H10N 30/30, H10N 30/853, H10N 30/87, G01L 1/16

(54) **OBJET FONCTIONNALISE AVEC CAPTEUR D'ONDES MECANIQUES INTEGRE ET PROCEDE DE FABRICATION ASSOCIE**
FUNKTIONALISIERTES OBJEKT MIT INTEGRIERTEM MECHANISCHEM WELLENSENSOR UND ZUGEHÖRIGES HERSTELLUNGSVERFAHREN
FUNCTIONALISED OBJECT WITH INTEGRATED MECHANICAL WAVE SENSOR AND ASSOCIATED PRODUCTION METHOD

(30) Priorité: 14.09.2020 FR 2009290
(43) Date de publication de la demande: 19.07.2023
(73) Titulaire: Wormsensing, 38040 Grenoble Cedex 9 (FR); Commissariat à l'Energie Atomique et aux Energies Alternatives, 75015 Paris (FR)
(72) Inventeur: BENAISSA, Lamine, 38000 GRENOBLE (FR); DEGIRMENCIOGLU, Ismail, 01130 NANTUA (FR); MOULET, Jean-Sébastien, 73000 CHAMBERY (FR)
(74) Mandataire: IP Trust
(86) Numéro de dépôt international: PCT/FR2021/051559
(87) Numéro de publication internationale: WO 2022/053771

(56) Documents cités:
- EP-A2- 0 561 616
- EP-A2- 3 226 664
- WO-A1-2015/055788
- US-A1- 2012 055 257
- US-A1- 2020 253 043

## Description

### DOMAINE DE L'INVENTION

La présente invention concerne le domaine de la fonctionnalisation d'objets avec des capacités de détection de d'ondes mécaniques. L'invention porte sur un objet fonctionnalisé par l'intégration d'un capteur d'ondes mécaniques sur une surface dudit objet.

### ARRIERE PLAN TECHNOLOGIQUE DE L'INVENTION

La détection et la mesure d'ondes mécaniques sont essentielles dans un grand nombre de domaines, dont par exemple, la maintenance préventive, le développement, le suivi, la calibration ou la surveillance (pour assurer la sécurité) d'équipements. Les champs d'applications peuvent s'étendre aux équipements grand public, aux outillages et équipements industriels (pompes, ...), ainsi qu'aux véhicules terrestres ou aériens.

Rappelons qu'une onde mécanique est un phénomène de propagation d'une perturbation dans un milieu matériel, sans transport de matière. La perturbation correspond à une variation d'une propriété mécanique (vitesse, position, énergie, etc.) des points d'un milieu matériel ; elle inclut les vibrations et les déformations.

Pour toutes applications industrielles ou liées au transport, une mesure précise de vibrations ou de déformations présente un atout majeur en maximisant le temps de disponibilité des équipements, en minimisant les coûts de maintenance et en évitant les réparations d'urgence.

Aujourd'hui, les mesures vibratoires passent par des dispositifs discrets que l'on fixe a posteriori sur l'objet (équipement ou partie de l'équipement) à fonctionnaliser. La fixation peut se faire notamment par vissage, avec une précaution particulière au niveau de la connectique (fils de connexion) qui ne doit pas vibrer lors du fonctionnement, sans quoi la mesure de vibration est fortement entachée d'erreur.

Le compromis pour la mesure d'ondes mécaniques est donc gouverné par l'adéquation performance x intégration x coût. Le niveau de performance, qui regroupe la plage de détection (fréquence), la précision (ratio signal sur bruit), et la compatibilité avec l'environnement, doit être suffisant. Le volume et la masse du dispositif de mesure doivent être suffisamment faibles pour que l'intégration dudit dispositif n'impacte pas négativement le système ou l'équipement cible. Enfin, les coûts d'assemblage et de traitement du signal doivent rester raisonnables pour favoriser un large déploiement des solutions de détection.

Les dispositifs de détection de vibrations et de déformations sont généralement réalisés à partir de matériaux piézoélectriques. Ces derniers peuvent consister en des céramiques massives, comme par exemple le titano-zirconate de plomb (PZT), ou en des polymères, comme notamment le polyvinylidine difluoride trifluoroéthylène (PVDF-trfe).

Les avantages d'une céramique sont la stabilité dans le temps et en température, ainsi que la haute performance, conférées au capteur ; un inconvénient vient néanmoins de la masse du capteur qui nécessite une contre masse pour éliminer la fréquence propre du capteur, et sa fragilité qui nécessite un packaging de protection volumineux qui impacte négativement le paramètre intégration. De plus, de tels capteurs, bases sur des couches épaisses de céramique (épaisseur entre 150 microns et quelques millimètres), n'ouvrent pas la possibilité à une intégration sur des pièces souples et flexibles.

Un capteur basé sur un polymère piézoélectrique est intrinsèquement flexible, car des couches polymères très minces sont réalisables (de quelques microns à quelques dizaines de microns) ; le niveau de performance et la tenue en température sont par contre bien moindres par rapport aux céramiques. Les polymères piézoélectriques souffrent également d'une instabilité de polarisation, qui affecte leur fiabilité dans le temps.

La demande de brevet US 2012/0055257 décrit un dispositif piézoélectrique, pour assurer la fonction de capteur de pression, forces ou vibrations et disposé sur un substrat de dispositif médical, le capteur piézoélectrique est obtenu par déposition d'un encre piézoélectrique sur une couche de support collée sur le substrat. L'encre piézoélectrique est obtenu par dissolution de particules (grains de cristaux) de matériau piézoélectrique dans un solution de polychlorure de vinyle durcie à 80°C après déposition.

La demande de brevet EP 3 226 664 décrit un système pour monitorage de l'état de structures mécaniques, comprenant de capteurs piézoélectriques, à base de nanoparticules, déposés sur une structure. Les capteurs piézoélectriques sont obtenus par déposition d'un encre piézoélectrique sur une couche de support collée sur la surface de l'objet. L'encre piézoélectrique est obtenu par dissolution de grains de cristaux de matériau piézoélectrique dans un solvant.

### OBJET DE L'INVENTION

La présente invention concerne une solution alternative à celles de l'état de la technique, qui vise à répondre aux objectifs de performance, intégration et coûts requis pour une utilisation large de la solution. L'invention concerne en particulier un objet fonctionnalisé par l'intégration d'un capteur d'ondes mécaniques en céramique et de sa connectique sur une surface dudit objet.

### BREVE DESCRIPTION DE L'INVENTION

La présente invention concerne un objet fonctionnalisé composé d'une matière présentant un coefficient d'absorption acoustique inférieur à 0,6 dans une plage de fréquences allant de 1Hz à 40kHz, et muni d'au moins un capteur d'ondes mécaniques procurant une capacité de détection de vibrations et de déformations audit objet,le capteur d'ondes mécaniques comporte : 1
- une cellule sensible présentant une épaisseur inférieure ou égale à 50 microns, et comprenant une couche active en matériau piézoélectrique monocristallin ou poly-cristallin et deux électrodes en contact avec la couche active et accessibles au niveau d'une première face de la cellule sensible, 1
- une couche support composée d'une matière identique à ou apte à adhérer à la matière composant l'objet, solidaire d'une deuxième face de la cellule sensible et solidaire de l'objet, ladite couche support étant intégrée à la matière de l'objet,et
l'objet fonctionnalisé comprend au moins deux pistes électriquement conductrices disposées sur la première face de la cellule sensible et sur une surface de l'objet, chaque piste reliant une électrode à un plot de connexion électrique.

Selon des caractéristiques avantageuses de l'invention, prises seules ou selon toute combinaison réalisable :
- la couche support est composée d'une matière identique à ou apte à adhérer à une matière composant l'objet ;
- tout ou partie de la couche support est intégrée à ou dans la matière de l'objet ;
- le matériau piézoélectrique est choisi parmi le titano-zirconate de Plomb (PZT), le nitrure d'aluminium (AlN), l'oxyde de zinc (ZnO), le tantalate de lithium (LiTaO3), le niobate de potassium (KNbO3), le niobate de lithium (LiNbO3), le titane de niobate de plomb et de magnésium (PMN-PT), le quartz, le titanate de strontium (SrTiO3), le titanate de baryum (BaTiO3) ;
- la couche active présente des ondulations de surface sous forme de rides, au moins du côté de la première face ;
- l'objet fonctionnalisé est composé d'au moins une matière choisie parmi le plastique tel qu'un polymère thermoplastique, le métal, les matrices à fibres de carbone et autres matériaux composites
- la couche support est formée dans un matériau choisi parmi le poly(méthacrylate de méthyle) (PMMA), le acrylonitrile butadiène styrène (ABS), le polyéthylène à haute densité (HDPE), le polypropylène polychlorure de vinyle (PVC), acrylonitrile de styrène (SAN), les acétals, le polybutylène téréphtalate (PBT), le polyéthylène téréphtalate (PET), le polycarbonate (PC), le polyétheréthercétone (PEEK), le polyétherimide (PEI), le polyéthersulfone polyéthylène ether (PPE), le polyamide (NYLON), le poly(sulfure de phénylène) (PPS), les matrices à fibres de carbone ;
- la couche support présente une épaisseur comprise entre 10 microns et 1mm ;
- l'objet fonctionnalisé comprend une pluralité de capteurs d'ondes mécaniques ;
- la pluralité de capteurs d'ondes mécaniques partage la même couche support ;
- la cellule sensible présente des dimensions latérales, au niveau de ses première et deuxième faces, comprises entre 500pm et 20cm ;
- l'objet fonctionnalisé forme un élément de structure de véhicule ou de bâtiment, une pièce de moteur, un cadre de bicyclette, un capot d'équipement industriel ou domestique, etc.

L'invention concerne également un procédé de fabrication d'un objet fonctionnalisé tel que ci-dessus, le procédé de fabrication comprenant les étapes suivantes :
a) la fourniture d'un capteur d'ondes mécaniques comportant :
   - une cellule sensible présentant une épaisseur inférieure ou égale à 50 microns, et comprenant une couche active en matériau piézoélectrique monocristallin ou poly-cristallin, et deux électrodes en contact avec la couche active et accessibles au niveau d'une première face de la cellule sensible,
   - une couche support présentant une face avant et une face arrière, sa face avant étant solidaire d'une deuxième face de la cellule sensible,
b) la formation en une matière solide d'un objet, par moulage, par injection ou par impression en trois dimensions,
c) la solidarisation du capteur d'ondes mécaniques sur l'objet, au cours de l'étape b) en positionnant ledit capteur de telle sorte que la face arrière de la couche support au moins se trouve intégrée dans la matière formant l'objet et que les électrodes demeurent accessibles lorsque l'objet est formé,
d) le dépôt de deux pistes électriquement conductrices sur la première face de la cellule sensible et sur une surface de l'objet, chaque piste reliant une électrode à un plot de connexion électrique aménagé sur ladite surface.

Selon des caractéristiques avantageuses de l'invention, prises seules ou selon toute combinaison réalisable :
- le capteur d'ondes mécaniques fourni à l'étape a) comprend une couche de manipulation temporaire disposée sur la face arrière de la couche support, et cette couche de manipulation est retirée avant l'étape c) de solidarisation du capteur d'ondes mécaniques sur l'objet ;
- l'étape a) comprend la fourniture d'une pluralité de capteurs d'ondes mécaniques partageant la même couche support, et l'étape c) comprend la solidarisation simultanée de la pluralité de capteurs d'ondes mécaniques sur l'objet ;
- l'étape d) est opérée par sérigraphie, par spray, par croissance électrolytique ou par frittage laser direct de métaux.

### BREVE DESCRIPTION DES DESSINS

D'autres caractéristiques et avantages de l'invention ressortiront de la description détaillée qui va suivre en référence aux figures annexées sur lesquelles :

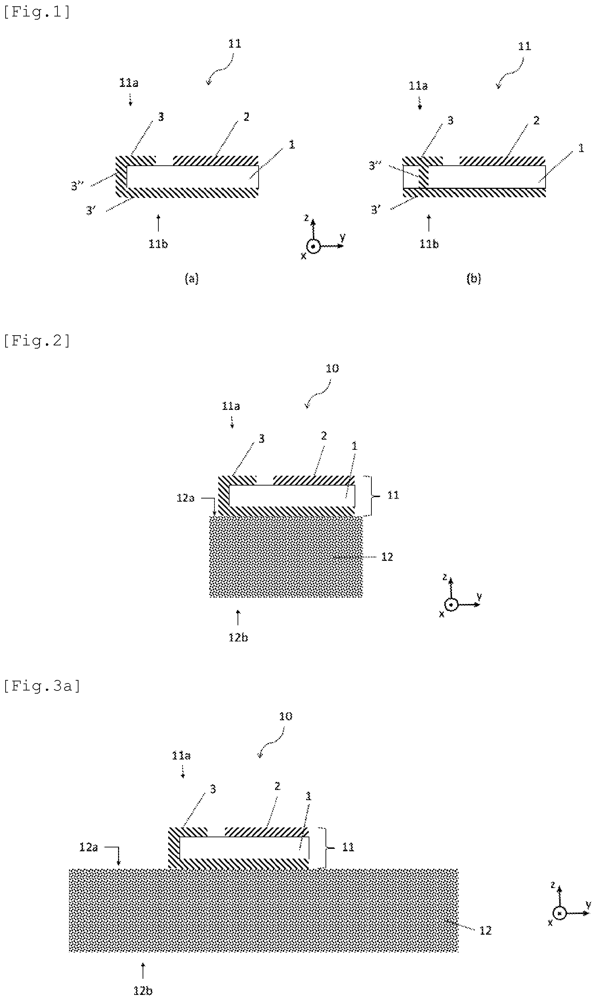

[Fig. 1] La figure 1 présente des variantes de cellules sensibles d'un capteur d'ondes mécaniques destiné à être intégré à l'objet fonctionnalisé conforme à l'invention ;
[Fig. 2]
[Fig. 3a]
[Fig. 3b]
[Fig. 4] Les figures 2, 3a, 3b et 4 présentent des variantes de capteurs d'ondes mécaniques destinés à être intégrés à un objet fonctionnalisé conforme à l'invention ;
[Fig. 5a]
[Fig. 5b] Les figures 5a et 5b présentent un objet fonctionnalisé conforme à l'invention ;
[Fig. 6] La figure 6 présente des étapes d'un procédé de fabrication d'un objet fonctionnalisé, selon un premier mode de réalisation de l'invention ;
[Fig. 7] La figure 7 présente des étapes d'un procédé de fabrication d'un objet fonctionnalisé, conforme à l'invention.

Les figures sont des représentations schématiques qui, dans un objectif de lisibilité, ne sont pas nécessairement à l'échelle. Les mêmes références sur les figures pourront être utilisées pour des éléments de même nature.

Les différentes possibilités (variantes et modes de réalisation illustrés et/ou détaillés dans la description à suivre) doivent être comprises comme n'étant pas exclusives les unes des autres et peuvent se combiner entre elles.

### DESCRIPTION DETAILLEE DE L'INVENTION

L'invention concerne un objet fonctionnalisé 100 muni d'au moins un capteur d'ondes mécaniques 10 procurant une capacité de détection de vibrations et de déformations audit objet 100. Comme énoncé en introduction, la détection et la mesure de vibrations et de déformations peuvent s'avérer importantes dans différents domaines, notamment pour anticiper la dégradation de certaines pièces mécaniques : par exemple, avec l'apparition de fissures ou autres défauts structurels dans ces pièces, la signature fréquentielle des ondes acoustiques va changer et peut alerter avant la casse de la pièce ou l'apparition d'autres défaillances critiques. Sans que cela ne forme une liste exhaustive, l'objet fonctionnalisé 100 peut notamment consister en :
- un élément de structure de véhicule, par exemple tout ou partie d'une aile d'avion, un châssis de voiture, un cadre de bicyclette, ...
- une pièce de moteur, par exemple un capot de carburateur, un élément de turbine, un arbre, un roulement ...
- un élément de structure de bâtiment,
- un élément d'équipement industriel ou domestique, par exemple, une pompe, ...
- en général, une pièce en matériaux composites pour lesquels une modélisation de fatigue ou de rupture est complexe, et qui peut tirer un grand bénéfice de la présence d'un capteur d'ondes mécaniques pour anticiper l'apparition de défauts dans sa structure.

L'objet fonctionnalisé 100 selon l'invention intègre un capteur d'ondes mécaniques 10 qui comporte une cellule sensible 11 solidaire d'une couche support 12, laquelle est solidaire de l'objet 100.

La cellule sensible 11 se présente généralement sous forme d'une vignette, dont les faces principales 11a, 11b (nommées par la suite première face 11a et deuxième face 11b) s'étendent dans le plan (x,y) sur la figure 1. Elle présente des dimensions latérales, dans le plan (x,y), comprises entre 0.2 mm et quelques cm, typiquement entre 0.5mm et 5cm. La cellule sensible 11 du capteur 10 présente en outre une épaisseur totale (selon l'axe z sur les figures) inférieure ou égale à 50 microns, avantageusement inférieure ou égale à 30 microns. Elle comprend une couche active 1 en matériau piézoélectrique de type céramique et deux électrodes 2,3 en contact avec la couche active 1 et accessibles au niveau de la première face 11a de la cellule sensible 11. Le matériau piézoélectrique, monocristallin ou poly-cristallin, est par exemple choisi parmi le titano-zirconate de Plomb (PZT), le nitrure d'aluminium (AlN), l'oxyde de zinc (ZnO), le tantalate de lithium (LiTaO3), le niobate de potassium (KNbO3), le niobate de lithium (LiNbO3), le titane de niobate de plomb et de magnésium (PMN-PT), le quartz, le titanate de strontium (SrTiO3) et le titanate de baryum (BaTiO3).

La couche active 1 présente une épaisseur typiquement comprise entre 500 nm et 40 microns.

Selon un mode de réalisation avantageux, la couche active 1 présente des ondulations de surface sous forme de rides, au moins du côté de la première face 11a de la cellule sensible 11. Des procédés de formation de telle ondulations de surface sont décrit dans les documents WO2015/055788, WO2015/055783 et WO2015/055786, et s'appliquent par exemple pour la réalisation de la cellule sensible 11 de la présente invention.

Les électrodes 2,3 de la cellule sensible 11 sont formées en matériau métallique et sont en contact intime avec la couche active 1 : elles assurent la collecte des charges générées par effet piézoélectrique lors de la déformation de la couche active 1. Une déformation de la couche active 1 apparaît en particulier lorsque celle-ci est soumise à une onde mécanique. Le signal électrique généré aux bornes des électrodes 2,3 est représentatif de l'intensité et de la fréquence de la déformation liée à l'onde mécanique.

Comme illustré sur la figure 1, les deux électrodes 2,3 sont accessibles au niveau de la première face 11a de la cellule 11. Habituellement, les électrodes 2,3 sont disposées de part et d'autre de la couche active 1, c'est-à-dire du côté de la première face 11a et du côté de la deuxième face 11b de la cellules sensible 11, pour bénéficier de l'effet piézoélectrique sur l'épaisseur entière de la couche active 1. Ainsi, dans la configuration (a) de la figure 1, l'électrode 3 comprend une portion inférieure 3' au niveau de la deuxième face 11b, une portion latérale 3" disposée sur la tranche de la couche active 1 et une portion supérieure au niveau de la première face 11a de la cellule sensible 11. Dans la configuration (b) de la figure 1, un via conducteur 3" vient relier électriquement la portion inférieure 3' et la portion supérieure de l'électrode 3. Dans ces deux configurations, les deux électrodes 2,3 se trouvent accessibles au niveau de la première face 11a de la cellule sensible 11.

Les électrodes 2,3 présentent une épaisseur (selon l'axe z) typiquement comprise entre 50nm et 25 microns. Elles peuvent comprendre un matériau conducteur électrique, choisi parmi l'aluminium, l'or, le titane, l'argent, le tungstène, le cuivre, le nickel ou les alliages métalliques conducteurs ; elles peuvent également comprendre d'autres couches de type barrières de diffusion (nitrure de titane TiN, nitrure de tantale TaN, nitrure de tungstène WN).

Le capteur d'ondes mécaniques 10 comprend également une couche support 12 dont une face avant 12a est solidaire de la deuxième face 11b de la cellule sensible 11 (figure 2). La couche support 12 présente typiquement une épaisseur comprise entre 10 microns et 1mm, par exemple 200 microns.

Avantageusement, la couche support 12 est composée d'un matériau identique à une matière composant l'objet fonctionnalisé 100, ou apte à adhérer à ladite matière. En effet, comme cela sera décrit plus loin en référence à un mode de réalisation du procédé de fabrication selon l'invention, la couche support 12 peut être intégrée à la matière de l'objet 100 par exemple au cours d'étapes de moulage, injection ou impression en trois dimensions : il est donc important que le matériau de la couche support 12 soit compatible avec la matière de l'objet 100 et permette une intégration fiable et de qualité dans la matière de l'objet fonctionnalisé 100.

Sans que cela soit limitatif, l'objet fonctionnalisé peut être composé d'au moins une matière choisie parmi le plastique tel qu'un polymère thermoplastique, le métal, les matrices à fibres de carbone, à fibres de verre, les tissus d'aramide, de polypropylène de haut poids moléculaire de fibres naturelles, de fibres de basalte, et autres matériaux composites, à l'exclusion des matières présentant un coefficient d'absorption acoustique égal ou supérieur à 0,6 dans la plage de fréquences allant de 1Hz à 40 kHz. Il est compréhensible que les matières à trop fort coefficient d'absorption acoustique ne soient pas compatibles avec le principe de mesure par le capteur d'ondes mécaniques 10 intégré selon l'invention. L'objet fonctionnalisé 100 est donc formé d'une (ou plusieurs) matière(s) autorisant une propagation suffisante des ondes acoustiques.

A titre d'exemples, la couche support 12 est formée dans un matériau choisi parmi le poly(méthacrylate de méthyle) (PMMA), le acrylonitrile butadiène styrène (ABS), le polyéthylène à haute densité (HDPE), le polypropylène polychlorure de vinyle (PVC), acrylonitrile de styrène (SAN), les acétals, le polybutylène téréphtalate (PBT), le polyéthylène téréphtalate (PET), le polycarbonate (PC), le polyétheréthercétone (PEEK), le polyétherimide (PEI), le polyéthersulfone polyéthylène ether (PPE), le polyamide (NYLON), le poly(sulfure de phénylène) (PPS), les polyépoxydes et les matrices à fibres de carbone.

Selon une première variante, la couche support 12 présente sensiblement les mêmes dimensions latérales (dans le plan (x,y)) que la cellule sensible 11 (figure 2).

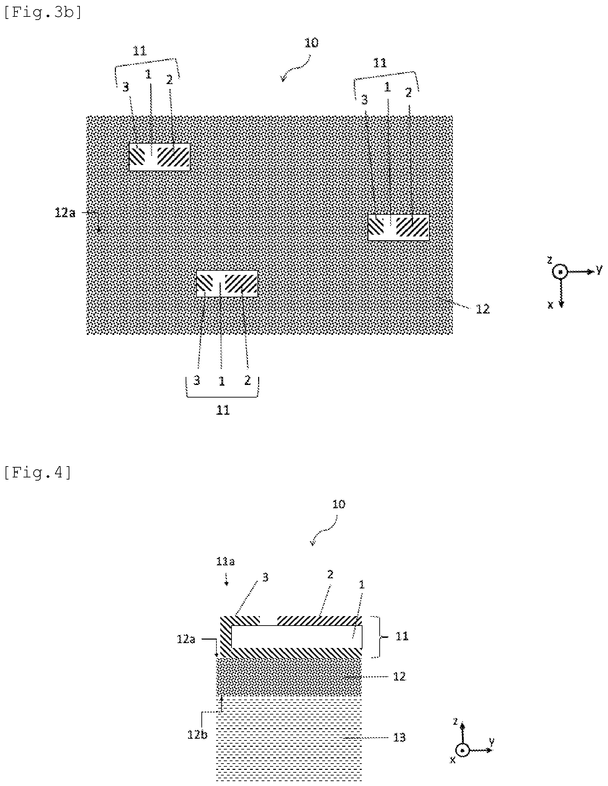

Selon une deuxième variante, la couche support 12 présente des dimensions supérieures à celles de la cellule 11, comme illustré sur les figures 3a (en coupe) et 3b (en vue plane) : la cellule sensible 11 représente par exemple une vignette disposée sur une feuille de plus grandes dimensions faisant office de couche support 12. Une telle configuration peut faciliter le positionnement de la cellule sensible 11 lors de sa solidarisation sur l'objet fonctionnalisé 100 ; cela sera décrit en référence au procédé de fabrication objet de l'invention. Toujours dans la deuxième variante, il est envisageable d'avoir plusieurs cellules sensibles 11 sur la même couche support 12 (figure 3b). Cela permet notamment l'intégration d'une pluralité de capteurs d'ondes mécaniques 10 sur le même objet 100, lesdits capteurs 10 partageant une même couche support 12. Cette variante autorise également un positionnement aisé et précis des cellules sensibles 11 sur la couche support 12 plane, préalablement à l'intégration de l'ensemble (capteurs 10) sur l'objet 100, qui pourra être plan ou courbe.

Enfin, selon une troisième variante, le capteur d'ondes mécaniques 10 comprend une couche de manipulation 13, temporairement attachée à la face arrière 12b de la couche support 12 (figure 4). Cette couche de manipulation 13 permet en particulier de manipuler le capteur 10 lorsque son épaisseur totale est faible, notamment inférieure à 50 microns, voire inférieure à 20 microns. A titre d'exemple, elle peut consister en un film plastique auto-adhésif en poly-téréphtalate d'éthylène (PET). La couche de manipulation 13 est temporaire et est destinée à être retirée avant la solidarisation du capteur 10 sur l'objet 100.

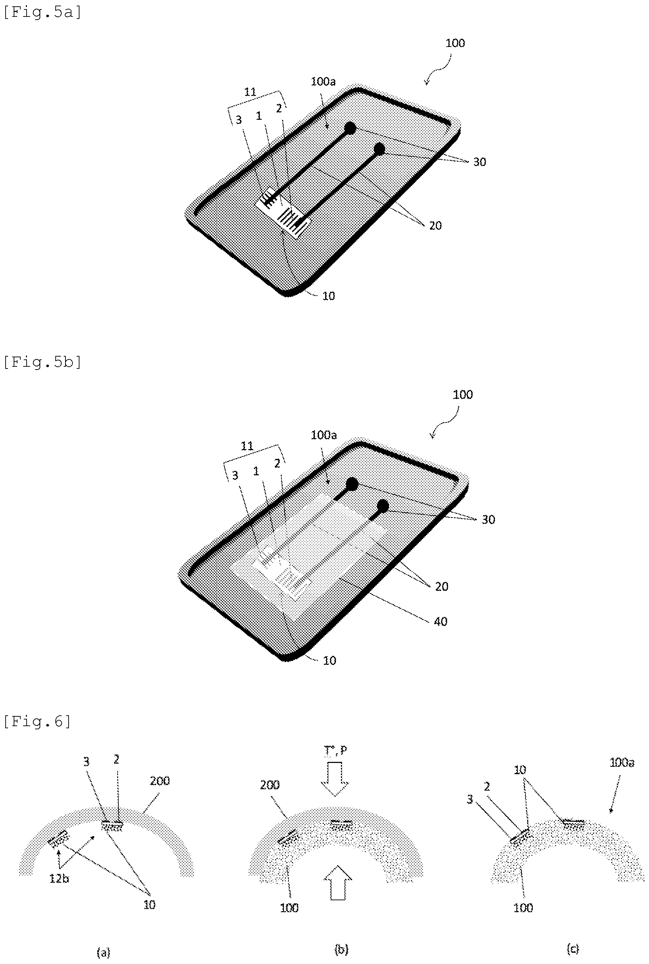

Ainsi, quelle que soit la variante considérée, une face arrière 12b de la couche support 12 est solidaire de l'objet 100, comme par exemple illustré sur la figure 5a.

Selon l'invention, l'objet fonctionnalisé 100 comprend en outre au moins deux pistes 20, électriquement conductrices, disposées sur la première face 11a de la cellule sensible 11 et sur une surface 100a de l'objet 100 (figure 5a). Chaque piste 20 relie électriquement une électrode 2,3 à un plot de connexion électrique 30. Les pistes 20 peuvent être constituées d'un matériau choisi parmi l'argent, le cuivre, l'aluminium, une pâte à base de carbone.

Le signal électrique généré par le capteur 10 est donc destiné à être récupéré au niveau des plots de connexion 30 et transmis à un contrôleur ou à une unité électronique capable de traiter et interpréter le signal.

Les pistes sont déposées sur et sont solidaires de la surface 100a de l'objet fonctionnalisé 100. Cela permet d'éliminer tout problème de vibration de la connectique du capteur d'ondes mécaniques 10, laquelle est susceptible d'entacher d'erreur les mesures dudit capteur.

Dans certains cas, un film isolant 40 peut être disposé sur les pistes conductrices 20, sur le capteur d'ondes mécaniques 10 et sur une partie de la surface 100a de l'objet 100, de manière à isoler et protéger l'ensemble (figure 5b).

Dans l'exemple des figures 5a et 5b, l'objet fonctionnalisé 100 prend la forme d'un capot plan, pour faciliter sa représentation. Il pourrait bien sûr prendre n'importe quelle forme, plane, courbée ou plus complexe, en fonction des domaines et applications visées.

L'objet fonctionnalisé 100 selon l'invention est capable de détecter avec précision des ondes mécaniques (vibrations ou déformations) se développant dans l'objet, grâce à l'intégration du capteur 10 tel que précédemment décrit. La cellule sensible 11 est basée sur un matériau piézoélectrique cristallin, ce qui lui assure une excellente sensibilité et une grande fiabilité de mesure. Par ailleurs, la faible épaisseur de la cellule sensible 11 évite de prendre des contre-mesures quant à la fréquence propre du cristal de la couche active 1. Les pistes conductrices 20 déposées directement sur la surface 100a de l'objet 100 autorisent une connectique efficace, laquelle n'apporte pas de bruit à la mesure du capteur 10. En outre, le capteur d'ondes mécaniques 10 avec sa connectique 20 n'apporte qu'une très faible masse supplémentaire à l'objet fonctionnalisé 100, de par ses dimensions et sa composition.

Enfin, le capteur d'ondes mécaniques 10 est particulièrement aisé à intégrer à l'objet 100 du fait de sa couche support 12 : la solidarisation de la couche support 12 sur ledit objet 100 ou dans la matière dudit objet 100 permet de positionner aisément et précisément une ou plusieurs couches sensibles 10 dans une zone d'intérêt de l'objet 100.

L'invention concerne également un procédé de fabrication d'un objet fonctionnalisé 100 tel que décrit ci-dessus. Le procédé de fabrication comprend une première étape a) de fourniture d'un capteur d'ondes mécaniques 10. Ce dernier comprend une cellule sensible 11 solidaire d'une couche support 12. Les caractéristiques de la cellule sensible 11 et de la couche support 12 sont celles décrites précédemment et ne sont donc pas reprises ici.

L'assemblage de la cellule sensible 11 sur la couche support 12 peut être fait par les techniques connues de collage adhésif. Alternativement, la couche support 12 peut être déposée sur la deuxième face de la cellule sensible 11, par exemple par enduction centrifuge (« spin coating » selon la terminologie anglo-saxonne) ou coulage en bande, trempage (« dip coating »), dépôt par pulvérisation (« spray coating »), sérigraphie. On pourra notamment se reporter à la publication de T.Dufay et al concernant un procédé de transfert d'un film mince de PZT sur un support en polymère (« New process for transferring PZT thin film onto polymer substrate », 2016 Joint IEEE International Symposium on the Applications of Ferroelectrics, European Conférence on Application of Polar Dielectrics, and Piezoelectric Force Microscopy Workshop (ISAF/ECAPD/PFM)).

A l'étape a) du procédé, une ou plusieurs couche(s) sensible(s) 11 (pour former respectivement un ou plusieurs capteur(s) d'ondes mécaniques 10) est/sont solidaire(s) de la couche support 12 et peut/peuvent être positionnée(s) avec précision sur cette dernière par des techniques connues (par exemple, « pick and place »).

Le procédé comprend ensuite une étape b) de formation, en une matière solide, de l'objet 100 destiné à être fonctionnalisé. Cette étape est basée sur du moulage, du thermoformage, de l'injection ou de l'impression en trois dimensions, techniques connues de l'état de l'art.

L'objet 100 peut par exemple être composé d'au moins une matière choisie parmi le plastique (tel qu'un polymère thermoplastique), le métal, les matrices à fibres de carbone, à fibres de verre, les tissus d'aramide, de polypropylène de haut poids moléculaire de fibres naturelles, de fibres de basalte, et autres matériaux composites ou combinaisons des matières précitées. Selon la présente invention, l'objet 100 est composé d'une ou plusieurs matière(s) présentant un coefficient d'absorption acoustique inférieur à 0,6 dans la plage de fréquences allant de 1Hz à 40kHz, de manière à autoriser la propagation d'ondes mécaniques dans la ou lesdites matière(s).

Le procédé de fabrication comprend également une étape c) de solidarisation du capteur d'ondes mécaniques 10 sur l'objet 100. Cette étape peut être opérée selon différents modes de réalisation.

Selon un premier mode de réalisation, cette étape de solidarisation s'effectue au cours de l'étape b), en positionnant ledit capteur 10 de telle sorte que la face arrière 12b de la couche support 12 au moins se trouve intégrée dans la matière formant l'objet 100 et que les électrodes 2,3 demeurent accessibles lorsque l'objet 100 est formé.

Dans l'exemple illustré sur la figure 6, le (ou les) capteur(s) 10 est(sont) maintenu(s) dans un moule 200, typiquement par un système de préhension par le vide ; les électrodes 2,3 sont placées du côté du moule 200 (figure 6 (a)). La matière, par exemple thermoplastique ou en une matière composite telle qu'évoquée précédemment, destinée à former l'objet 100 est introduite dans le moule et soumise à des conditions de température et de pression permettant le moulage de l'objet 100 (figure 6 (b)). Alternativement, le (ou les) capteur(s) 10 sont associés à la matière destinée à former l'objet 100, avant l'introduction de l'ensemble dans le moule 200.

Lorsque l'objet 100 est retiré du moule 200, le (ou les) capteur(s) d'ondes mécaniques 10 se trouve(nt) intégré(s) dans la matière de l'objet 100. Cette intégration est d'autant plus fiable que le matériau de la couche support 12 est choisi identique à celui de l'objet 100, ou compatible avec ce dernier en termes d'adhérence et avec la technique de formation de l'objet 100 : tout ou partie du matériau de la couche support 12 peut être inter-mixé ou avoir inter-diffusé avec la matière de l'objet 100. La cellule sensible 11, en matériaux cristallin et métallique supporte sans problème les techniques énoncées de formation de l'objet 100.

Selon un mode de réalisation, non couvert par le texte des revendications, la solidarisation du capteur d'ondes mécaniques 10 est opérée après l'étape b), en fixant par adhésion la face arrière 12b de la couche support 12 sur une surface 100a de l'objet 100 formé. L'adhésion peut être obtenue au moyen d'une colle, telle que par exemple une colle cyanoacrylate ou acrylique, par thermocompression ou par dissolution.

Selon l'un ou l'autre des modes de réalisation, l'étape a) peut comprendre la fourniture d'une pluralité de capteurs d'ondes mécaniques 10 partageant ou non la même couche support 12, comme évoqué en référence à la figure 3b. Dans ce cas, l'étape c) comprend la solidarisation simultanée de la pluralité de capteurs d'ondes mécaniques 10 sur l'objet 100. Dans le cas particulier où les capteurs 10 partagent la même couche support 12, on peut imaginer que cette dernière présente une forme et/ou des dimensions particulières, adaptées pour positionner avec précision les capteurs 10 dans le moule 200 ou en vis-à-vis de l'objet 100 sur lequel ils doivent être intégrés ou assemblés. Il est également aisé de munir les zones de l'objet 100 difficilement accessibles (par exemple des angles) de capteurs 10, par le positionnement adapté de la couche support 12 dans le moule 200, les cellules sensibles 11 ayant été préalablement réparties sur la couche support 12 en connaissance de la géométrie de l'objet 100.

Selon une variante, également compatible avec le premier et le deuxième mode de réalisation précités, le capteur d'ondes mécaniques 10 fourni à l'étape a) comprend une couche de manipulation 13 temporaire, disposée sur la face arrière 12b de la couche support 12. Une telle couche 13 est retirée avant l'étape c) de solidarisation du capteur d'ondes mécaniques 10 sur l'objet 100.

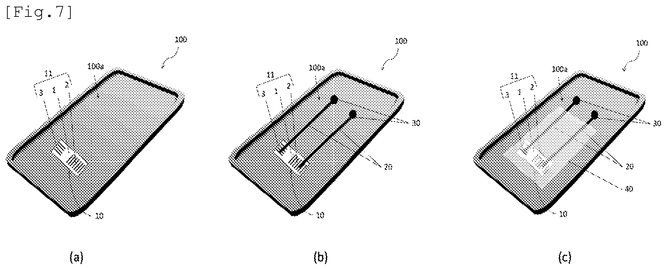

Après la solidarisation du capteur d'ondes mécaniques 10 sur une surface 100a de l'objet 100 (figure 7 (a)), le procédé de fabrication selon l'invention comprend une étape d) de dépôt de deux pistes électriquement conductrices 20 sur la première face 11a de la cellule sensible 11 du capteur 10 et sur la surface 100a de l'objet 100 (figure 7 (b)). Chaque piste conductrice 20 relie électriquement une électrode 2,3 à un plot de connexion électrique 30 aménagé sur ladite surface 100a. Un traitement de désoxydation (à base d'acide dilué, par exemple), appliqué à la surface du plot de connexion 30 et/ou à la surface des électrodes 2,3, pourra être mis en œuvre pour garantir un contact électrique conducteur avec les pistes 20.

En pratique, l'étape d) peut être opéré par sérigraphie, par spray, par croissance électrolytique ou par frittage laser direct de métaux.

Avantageusement, après la formation des pistes conductrices 20, une couche isolante 40 est déposée sur le capteur 10, sur lesdites pistes 20 et sur une partie de la surface 100a de l'objet 100, pour isoler et protéger l'ensemble.

La couche isolante 40 est par exemple en résine époxy, en polyuréthanes, ou encore en silicone (par exemple, élastomère silicone vulcanisable à froid ou RTV pour « room température vulcanisation ») ; elle peut être déposée par sérigraphie, enduction, spray, etc.

Bien sûr, l'invention n'est pas limitée aux modes de réalisation décrits et on peut y apporter des variantes de réalisation sans sortir du cadre de l'invention tel que défini par les revendications.

## Revendications

1. Objet fonctionnalisé (100) et muni d'au moins un capteur d'ondes mécaniques (10) procurant une capacité de détection de vibrations et de déformations audit objet, l'objet fonctionnalisé (10) étant **caractérisé en ce que** il est composé d'une matière présentant un coefficient d'absorption acoustique inférieur à 0,6 dans une plage de fréquences allant de 1Hz à 40kHz, 1
et **en ce que** le capteur d'ondes mécaniques (10) comporte :
- une cellule sensible (11) présentant une épaisseur inférieure ou égale à 50 microns, et comprenant une couche active (1) en matériau piézoélectrique monocristallin ou poly-cristallin et deux électrodes (2,3) en contact avec la couche active (1) et accessibles au niveau d'une première face (11a) de la cellule sensible (11),
- une couche support (12) composée d'une matière identique à ou apte à adhérer à la matière composant l'objet (100), solidaire d'une deuxième face (11b) de la cellule sensible (11) et solidaire de l'objet (100), ladite couche support (12) étant intégrée à la matière de l'objet (100),
et **en ce que** l'objet fonctionnalisé (100) comprend au moins deux pistes électriquement conductrices (20) disposées sur la première face (11a) de la cellule sensible (11) et sur une surface (100a) de l'objet (100), chaque piste (20) reliant une électrode (2,3) à un plot de connexion électrique (30).

2. Objet fonctionnalisé (100) selon la revendication précédente, dans lequel le matériau piézoélectrique est choisi parmi le titano-zirconate de Plomb (PZT), le nitrure d'aluminium (AlN), l'oxyde de zinc (ZnO), le tantalate de lithium (LiTaO3), le niobate de potassium (KNbO3), le niobate de lithium (LiNbO3), le titane de niobate de plomb et de magnésium (PMN-PT), le quartz, le titanate de strontium (SrTiO3), le titanate de baryum (BaTiO3).

3. Objet fonctionnalisé (100) selon l'une des revendications précédentes, dans lequel la couche active (1) présente des ondulations de surface sous forme de rides, au moins du côté de la première face (11a).

4. Objet fonctionnalisé (100) selon l'une des revendications précédentes, composé d'au moins une matière choisie parmi le plastique tel qu'un polymère thermoplastique, le métal, les matrices à fibres de carbone, à fibres de verre, les tissus d'aramide, de polypropylène de haut poids moléculaire de fibres naturelles, de fibres de basalte, et autres matériaux composites.

5. Objet fonctionnalisé (100) selon l'une des revendications précédentes, dans lequel la couche support (12) est formée dans un matériau choisi parmi le poly(méthacrylate de méthyle) (PMMA), le acrylonitrile butadiène styrène (ABS), le polyéthylène à haute densité (HDPE), le polypropylène polychlorure de vinyle (PVC), acrylonitrile de styrène (SAN), les acétals, le polybutylène téréphtalate (PBT), le polyéthylène téréphtalate (PET), le polycarbonate (PC), le polyétheréthercétone (PEEK), le polyétherimide (PEI), le polyéthersulfone polyéthylène ether (PPE), le polyamide (NYLON), le poly(sulfure de phénylène) (PPS), les polyépoxydes, les matrices à fibres de carbone.

6. Objet fonctionnalisé (100) selon l'une des revendications précédentes, dans lequel la couche support (12) présente une épaisseur comprise entre 10 microns et 1mm.

7. Objet fonctionnalisé (100) selon l'une des revendications précédentes, comprenant une pluralité de capteurs d'ondes mécaniques (10).

8. Objet fonctionnalisé (100) selon la revendication précédente, dans lequel la pluralité de capteurs d'ondes mécaniques (10) partage la même couche support (12).

9. Objet fonctionnalisé (100) selon l'une des revendications précédentes, formant un élément de structure de véhicule ou de bâtiment, une pièce de moteur, un cadre de bicyclette, ou un capot d'équipement industriel ou domestique.

10. Procédé de fabrication d'un objet fonctionnalisé (100) selon l'une des revendications précédentes, le procédé de fabrication comprenant les étapes suivantes :
a) la fourniture d'un capteur d'ondes mécaniques (10) comportant :
- une cellule sensible (11) présentant une épaisseur inférieure ou égale à 50 microns, et comprenant une couche active (1) en matériau piézoélectrique monocristallin ou poly-cristallin, et deux électrodes (2,3) en contact avec la couche active (1) et accessibles au niveau d'une première face (11a) de la cellule sensible (11),
- une couche support (12) présentant une face avant (12a) et une face arrière (12b), sa face avant (12a) étant solidaire d'une deuxième face (11b) de la cellule sensible (11), puis
b) la formation en une matière solide d'un objet, par moulage, par injection ou par impression en trois dimensions,
c) la solidarisation du capteur d'ondes mécaniques (10) sur l'objet, au cours de l'étape b) en positionnant ledit capteur (10) de telle sorte que la face arrière (12b) de la couche support (12) au moins se trouve intégrée dans la matière formant l'objet et que les électrodes (2,3) demeurent accessibles lorsque l'objet est formé, puis
d) le dépôt de deux pistes électriquement conductrices (20) sur la première face (11a) de la cellule sensible (11) et sur une surface (100a) de l'objet (100), chaque piste (20) reliant une électrode (2,3) à un plot de connexion électrique (30) aménagé sur ladite surface (100a).

11. Procédé de fabrication d'un objet fonctionnalisé (100) selon la revendication précédente, dans lequel :
- le capteur d'ondes mécaniques (10) fourni à l'étape a) comprend une couche de manipulation temporaire (13) disposée sur la face arrière (12b) de la couche support (12), et
- cette couche de manipulation (13) est retirée avant l'étape c) de solidarisation du capteur d'ondes mécaniques (10) sur l'objet (100).

12. Procédé de fabrication selon l'une des deux revendications précédentes, dans lequel :
- l'étape a) comprend la fourniture d'une pluralité de capteurs d'ondes mécaniques (10) partageant la même couche support (12), et
- l'étape c) comprend la solidarisation simultanée de la pluralité de capteurs d'ondes mécaniques (10) sur l'objet (100) .

13. Procédé de fabrication selon l'une des trois revendications précédentes, dans lequel l'étape d) est opérée par sérigraphie, par spray, par croissance électrolytique ou par frittage laser direct de métaux.

## Patentansprüche

1. Funktionalisiertes Objekt (100) und ausgestattet mit mindestens einem Sensor (10) für mechanische Wellen, der eine Fähigkeit zum Erkennen von Schwingungen und Verformungen an dem Objekt bietet, wobei das funktionalisierte Objekt (10) **dadurch gekennzeichnet ist, dass** es aus einem Material besteht, das einen Schallabsorptionskoeffizienten von weniger als 0,6 in einem Frequenzbereich von 1 Hz bis 40 kHz vorweist,
**und dadurch, dass** der Sensor (10) für mechanische Wellen aufweist:
- eine empfindliche Zelle (11), die eine Dicke von weniger als oder gleich 50 Mikrometern vorweist, und umfassend eine aktive Schicht (1) aus monokristallinem oder polykristallinem piezoelektrischem Material und zwei Elektroden (2,3), die in Kontakt mit der aktiven Schicht (1) und an einer ersten Fläche (11a) der empfindlichen Zelle (11) zugänglich sind,
- eine Trägerschicht (12), die aus einem Material besteht, das mit dem Material, aus dem das Objekt (100) besteht, identisch ist oder geeignet ist, an diesem zu haften, die mit einer zweiten Fläche (11b) der empfindlichen Zelle (11) fest verbunden und mit dem Objekt (100) fest verbunden ist, wobei die Trägerschicht (12) in das Material des Objekts (100) integriert ist, **und dadurch, dass** das funktionalisierte Objekt (100) mindestens zwei elektrisch leitende Bahnen (20) umfasst, die an der ersten Fläche (11a) der empfindlichen Zelle (11) und an einer Oberfläche (100a) des Objekts (100) angeordnet sind, wobei jede Bahn (20) eine Elektrode (2,3) mit einem elektrischen Anschlusspad (30) verbindet.

2. Funktionalisiertes Objekt (100) nach dem vorstehenden Anspruch, wobei das piezoelektrische Material ausgewählt ist aus: Bleititanzirkonat (PZT), Aluminiumnitrid (AIN), Zinkoxid (ZnO), Lithiumtantalat (LiTaO3), Kaliumniobat (KNbO3), Lithiumniobat (LiNbO3) und Bleiniobat- und Magnesiumtitan (PMN-PT), Quarz, Strontiumtitanat (SrTiO3), Bariumtitanat (BaTiO3).

3. Funktionalisiertes Objekt (100) nach einem der vorstehenden Ansprüche, wobei die aktive Schicht (1) mindestens an der Seite der ersten Fläche (11a) Oberflächenwelligkeiten in Form von Falten vorweist.

4. Funktionalisiertes Objekt (100) nach einem der vorstehenden Ansprüche, bestehend aus mindestens einem Material, das aus Kunststoff, wie einem thermoplastischen Polymer, Metall, Matrizen aus Kohlenstofffasern, Glasfasern, Aramidgeweben, hochmolekularen Polypropylen-Naturfasern, Basaltfasern und anderen Verbundwerkstoffen, ausgewählt ist.

5. Funktionalisiertes Objekt (100) nach einem der vorstehenden Ansprüche, wobei die Trägerschicht (12) aus einem Material ausgebildet ist, das aus Poly(methylmethacrylat) (PMMA), Acrylnitrilbutadienstyrol (ABS), Polyethylen hoher Dichte (HDPE), Polypropylenpolyvinylchlorid (PVC), Styrolacrylnitril (SAN), Acetalen, Polybutylenterephthalat (PBT), Polyethylenterephthalat (PET), Polycarbonat (PC), Polyetheretherketon (PEEK), Polyetherimid (PEI), Polyethersulfonpolyethylenether (PPE), Polyamid (NYLON), Poly(phenylensulfid) (PPS), Polyepoxiden, Kohlefasermatrizen ausgewählt ist.

6. Funktionalisiertes Objekt (100) nach einem der zwei vorstehenden Ansprüche, wobei die Trägerschicht (12) eine Dicke zwischen 10 Mikrometern und 1 mm vorweist.

7. Funktionalisiertes Objekt (100) nach einem der vorstehenden Ansprüche, umfassend eine Vielzahl von Sensoren (10) für mechanische Wellen.

8. Funktionalisiertes Objekt (100) nach dem vorstehenden Anspruch, wobei die Vielzahl von Sensoren (10) für mechanische Wellen die gleiche Trägerschicht (12) teilt.

9. Funktionalisiertes Objekt (100) nach einem der vorstehenden Ansprüche, das ein Strukturelement eines Fahrzeugs oder Gebäudes, ein Motorteil, einen Fahrradrahmen oder eine Abdeckung von Industrie- oder Haushaltsausrüstung ausbildet.

10. Verfahren zum Herstellen eines funktionalisierten Objekts (100) nach einem der vorstehenden Ansprüche, wobei das Herstellungsverfahren die folgenden Schritte umfasst:
a) Bereitstellen eines Sensors (10) für mechanische Wellen, aufweisend:
- eine empfindliche Zelle (11), die eine Dicke von weniger als oder gleich 50 Mikrometern vorweist, und umfassend eine aktive Schicht (1) aus monokristallinem oder polykristallinem piezoelektrischem Material und zwei Elektroden (2,3), die in Kontakt mit der aktiven Schicht (1) und an einer ersten Fläche (11a) der empfindlichen Zelle (11) zugänglich sind,
- eine Trägerschicht (12), die eine Stirnfläche (12a) und eine hintere Fläche (12b) vorweist, wobei ihre Stirnfläche (12a) mit einer zweiten Fläche (11b) der empfindlichen Zelle (11) fest verbunden ist, dann
b) Ausbilden eines Objekts aus einem festen Material durch Formen, durch Spritzen oder durch dreidimensionales Drucken,
c) festes Verbinden des Sensors (10) für mechanische Wellen an dem Objekt, während Schritt b) bei Positionieren des Sensors (10), sodass mindestens die hintere Fläche (12b) der Trägerschicht (12) in das Material integriert ist, das das Objekt ausbildet und dass die Elektroden (2,3) zugänglich bleiben, wenn das Objekt ausgebildet wird, dann
d) Abscheiden der zwei elektrisch leitenden Bahnen (20) an der ersten Fläche (11a) der empfindlichen Zelle (11) und an einer Oberfläche (100a) des Objekts (100), wobei jede Bahn (20) eine Elektrode (2,3) mit einem elektrischen Anschlusspad (30) verbindet, das an der Oberfläche (100a) eingerichtet ist.

11. Verfahren zum Herstellen eines funktionalisierten Objekts (100) nach dem vorstehenden Anspruch, wobei:
- der in Schritt a) bereitgestellte Sensor (10) für mechanische Wellen eine temporäre Manipulationsschicht (13) umfasst, die an der hinteren Fläche (12b) der Trägerschicht (12) angeordnet ist, und
- diese Manipulationsschicht (13) vor dem Schritt c) des festen Verbindens des Sensors (10) für mechanische Wellen an dem Objekt (100) entfernt wird.

12. Herstellungsverfahren nach einem der vorstehenden Ansprüche, wobei:
- Schritt a) das Bereitstellen einer Vielzahl von Sensoren (10) für mechanische Wellen umfasst, die sich die gleiche Trägerschicht (12) teilen, und
- Schritt c) das gleichzeitige feste Verbinden der Vielzahl von Sensoren (10) für mechanische Wellen an dem Objekt (100) umfasst.

13. Herstellungsverfahren nach einem der drei vorstehenden Ansprüche, wobei der Schritt d) durch Siebdruck, durch Sprühen, durch elektrolytisches Wachstum oder durch direktes Lasersintern von Metallen durchgeführt wird.

## Claims

1. Functionalized object (100) provided with at least one mechanical wave sensor (10) providing said object with a vibration and deformation detection capability, the functionalized object (10) being **characterized in that** it is composed of a material having an acoustic absorption coefficient lower than 0.6 in a frequency range from 1Hz to 40kHz,
**and in that** the mechanical wave sensor (10) comprises:
- a sensitive cell (11) having a thickness less than or equal to 50 microns, and comprising an active layer (1) made of monocrystalline or polycrystalline piezoelectric material and two electrodes (2, 3) in contact with the active layer (1) and accessible at a first surface (11a) of the sensitive cell (11),
- a support layer (12) composed of a material identical to or capable of adhering to the material making up the object (100), secured to a second face (11b) of the sensitive cell (11) and secured to the object (100), said support layer (12) being integrated into the material of the object (100), **and in that** the functionalized object (100) comprises at least two electrically conductive tracks (20) which are disposed on the first face (11a) of the sensitive cell (11) and on a surface (100a) of the object (100), each track (20) connecting an electrode (2, 3) to an electrical connection pad (30).

2. Functionalized object (100) according to the preceding claim,
wherein the piezoelectric material is chosen from lead titano-zirconate (PZT), aluminum nitride (AIN), zinc oxide (ZnO), lithium tantalate (LiTaO3), potassium niobate (KNbO3), lithium niobate (LiNbO3), lead magnesium niobate titanium
(PMN-PT), quartz, strontium titanate (SrTiO3) and barium titanate (BaTiO3).

3. Functionalized object (100) according to one of the preceding claims, wherein the active layer (1) has surface undulations in the form of wrinkles, at least on the side of the first face (11a).

4. Functionalized object (100) according to one of the preceding claims, composed of at least one material chosen from plastic, such as a thermoplastic polymer, metal, carbon fiber matrices, glass fibers, aramid fabrics, high molecular weight polypropylene from natural fibers, basalt fibers, and other composite materials.

5. Functionalized object (100) according to one of the preceding claims, wherein the support layer (12) is formed from a material chosen from poly(methyl methacrylate) (PMMA), acrylonitrile butadiene styrene (ABS), high-density polyethylene (HDPE), polypropylene polyvinyl chloride (PVC), acrylonitrile styrene (SAN), acetals, polybutylene terephthalate (PBT), polyethylene terephthalate (PET), polycarbonate (PC), polyetheretherketone (PEEK), polyetherimide (PEI), polyethersulfone polyethylene ether (PPE), polyamide (NYLON), poly(phenylene sulfide) (PPS), polyepoxides, carbon fiber matrices.

6. Functionalized object (100) according to one of the preceding claims, wherein the support layer (12) has a thickness of between 10 microns and 1 mm.

7. Functionalized object (100) according to one of the preceding claims, comprising a plurality of mechanical wave sensors (10).

8. Functionalized object (100) according to the preceding claim, wherein the plurality of mechanical wave sensors (10) shares the same support layer (12).

9. Functionalized object (100) according to one of the preceding claims, forming a vehicle or building structural element, an engine part, a bicycle frame or an industrial or domestic equipment cover.

10. Method for producing a functionalized object (100) according to one of the preceding claims, the production method comprising the following steps:
a) supplying a mechanical wave sensor (10) comprising:
- a sensitive cell (11) having a thickness less than or equal to 50 microns, and comprising an active layer (1) made of monocrystalline or polycrystalline piezoelectric material and two electrodes (2, 3) in contact with the active layer (1) and accessible at a first surface (11a) of the sensitive cell (11),
- a support layer (12) having a front surface (12a) and a rear surface (12b), its front surface (12a) being secured to a second face (11b) of the sensitive cell (11), then
b) forming an object in a solid material, by molding, by injection or by three-dimensional printing,
c) securing the mechanical wave sensor (10) to the object, during step b) by positioning said sensor (10) such that the rear surface (12b) of the support layer (12) is at least integrated into the material forming the object and such that the electrodes (2, 3) remain accessible when the object is formed, then
d) depositing two electrically conductive tracks (20) on the first face (11a) of the sensitive cell (11) and on a surface (100a) of the object (100), each track (20) connecting an electrode (2, 3) to an electrical connection pad (30) arranged on said surface (100a).

11. Method for producing a functionalized object (100) according to the previous claim, wherein:
- the mechanical wave sensor (10) provided in step a) comprises a temporary handling layer (13) disposed on the rear surface (12b) of the support layer (12), and
- this handling layer (13) is removed before step c) of securing the mechanical wave sensor (10) to the object (100).

12. Production method according to one of the two preceding claims, wherein:
- step a) comprises providing a plurality of mechanical wave sensors (10) sharing the same support layer (12), and
- step c) comprises simultaneously securing the plurality of mechanical wave sensors (10) to the object (100).

13. Production method according to one of the three preceding claims, wherein step d) is carried out by screen printing, by spraying, by electrolytic growth or by direct laser sintering of metals.
